# EUROPEAN PATENT SPECIFICATION

(11) **EP 3 982 134 B1**
(45) Date of publication and mention of the grant of the patent: **18.09.2024**
(21) Application number: 20201306.6
(22) Date of filing: 12.10.2020
(51) Int. Cl.: G01R 31/28

(54) **AUTOMATED QUALITY TESTING OF COMPONENT CARRIER STRUCTURE AFTER REMOVING MATERIAL**
AUTOMATISIERTE QUALITÄTSPRÜFUNG EINER KOMPONENTENTRÄGERSTRUKTUR NACH ENTFERNEN VON MATERIAL
TEST AUTOMATIQUE DE LA QUALITÉ D'UNE STRUCTURE DE SUPPORT DE COMPOSANT APRÈS ENLÈVEMENT DES MATÉRIAUX

(43) Date of publication of application: 13.04.2022
(73) Proprietor: AT & S Austria Technologie & Systemtechnik Aktiengesellschaft, 8700 Leoben-Hinterberg (AT)
(72) Inventor: Pacher, Gernot, 8750 Judenburg (AT); Titjung, Florian, 8605 Kapfenberg (AT); Schutting, Günter, 8605 Kapfenberg (AT); Gruber, Irene, 8793 Trofaiach (AT); Spitzer, Robert, 8680 Mürzzuschlag (AT); Schwaiger, Jürgen, 8621 Thörl (AT)
(74) Representative: Dilg, Haeusler, Schindelmann Patentanwaltsgesellschaft mbH

(56) References cited:
- WO-A1-2009/036331
- US-A- 4 592 138
- US-A- 4 648 212
- US-A- 4 858 479
- US-A- 5 006 295
- US-A1- 2001 024 119
- US-A1- 2005 190 959
- US-A1- 2015 212 114
- US-A1- 2016 291 079
- US-A1- 2020 319 230
- FRANK M: "OPTISCHES PRUFEN UNBESTUCKTER LEITERPLATTEN", ELEKTRONIK, W E K A FACHZEITSCHRIFTEN-VERLAG GMBH, DE, vol. 37, no. 6, 18 March 1988 (1988-03-18), pages 110 - 112, XP000021738, ISSN: 0013-5658
- "INSPECTING ASSEMBLED PCBS. ÖMANUAL OPTICAL TECHNIQUES DOMINATE IN ASSEMBLED BOARD INSPECTION, BUT AUTOMATED TECHNIQUES SUCH AS X-RAY OFFER A POWERFUL PROCESS CONTROL TOOL", ELECTRONIC PACKAGING AND PRODUCTION, CAHNERS PUBLISHING CO, NEWTON, MASSACHUSETTS, US, vol. 33, no. 9, 1 September 1993 (1993-09-01), pages 70 - 74, XP000413180, ISSN: 0013-4945

## Description

The invention relates to an apparatus for carrying out a quality test of a component carrier structure, a method of carrying out a quality test of a component carrier structure by an automated apparatus, a computer-readable medium, and a program element.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. At the same time, component carriers shall be mechanically robust and electrically reliable so as to be operable even under harsh conditions.

Cross-sectioning is a technique used to characterize materials, perform a failure analysis and expose an internal structure of a component carrier such as a printed circuit board (PCB). Cross-sectioning may involve mounting a target segment of the PCB in a potting material to obtain support and protect the PCB in a subsequent grinding and polishing process. The mounted PCB is carefully ground and then polished using progressively finer media to reach a target examination plane of interest. The PCB prepared in this way may then be inspected by a user, for instance under an optical microscope or a scanning electron microscope (SEM). Flat grinding is another technique for exposing an interior of a component carrier for inspection by a user.

Preparing and testing cross-sections of component carriers, flat ground component carriers, and related physical bodies is conventionally carried out manually by engineers. This holds for different types of microsections such as cross-sections and flat sections. However, this involves a high effort and a limited precision in terms of quality testing and may be critical concerning tough requirements regarding throughput on an industrial scale.

The documents US4,648,212, US4,858,479, US2005/190959A1 and WO2009/036331A1 disclose test systems for component carrier structures.

It is an object of the invention to assess quality of component carrier structures with high reliability, high throughput and reasonable effort.

In order to achieve the object defined above, an apparatus for carrying out a quality test of a component carrier structure, a method of carrying out a quality test of a component carrier structure by an automated apparatus, a computer-readable medium, and a program element according to the independent claims are provided.

According to the invention, an apparatus for carrying out a quality test of a component carrier structure is provided, wherein the apparatus comprises a handling unit configured for handling the component carrier structure at least along a portion between an inlet and an outlet of the apparatus, an identification unit configured for identifying the component carrier structure undergoing (or subjected to) the quality test, a material removal unit configured for removing material of the component carrier structure for exposing an interior of the component carrier structure undergoing (or subjected to) the quality test, a determining unit configured for determining at least one pre-defined test target of the component carrier structure after said material removal, and an evaluation unit configured for evaluating a characteristic of (for instance at least one attribute of) the determined at least one test target of the component carrier structure for assessing the quality of the component carrier structure.

According to the invention, a method of carrying out a quality test of a component carrier structure by an automated apparatus is provided, wherein the method comprises handling the component carrier structure at least along a portion between an inlet and an outlet of the apparatus, identifying the component carrier structure undergoing (or subjected to) the quality test, removing material of the component carrier structure for exposing an interior of the component carrier structure undergoing (or subjected to) the quality test, determining at least one pre-defined test target of the component carrier structure after said material removal, and evaluating a characteristic of (for instance at least one attribute of) the determined at least one test target of the component carrier structure for assessing the quality of the component carrier structure.

According to the invention, a program element (for instance a software routine, in source code or in executable code) is provided, which, when being executed by a processor (such as a microprocessor or a CPU), is adapted to cause an apparatus having the above-mentioned features to execute the steps of a method having the above mentioned features.

According to the invention, a computer-readable medium (for instance a CD, a DVD, a USB stick, an SD card, a floppy disk or a hard disk, or any other (in particular also smaller) storage medium) is provided, in which a computer program is stored which, when being executed by a processor (such as a microprocessor or a CPU), is adapted to cause an apparatus having the above-mentioned features to execute the steps of a method having the above mentioned features.

Data processing which may be performed according to embodiments of the invention can be realized by a computer program, that is by software, or by using one or more special electronic optimization circuits, that is in hardware, or in hybrid form, that is by means of software components and hardware components.

In the context of the present application, the term "component carrier" may particularly denote any support structure which is capable of accommodating one or more components thereon and/or therein for providing mechanical support and/or electrical connectivity and/or optical connectivity and/or thermal connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above-mentioned types of component carriers.

In the context of the present application, the term "component carrier structure" may particularly denote a thin sheet handled and processed during and/or after manufacturing component carriers, for instance a panel, an array or a component carrier itself. Thus, a component carrier structure may particularly denote a panel comprising multiple connected preforms of component carriers, an array (such as a quarter panel) comprising multiple connected preforms of component carriers, a preform of a component carrier (i.e. a component carrier which is not yet readily manufactured), or a readily manufactured component carrier (such as a printed circuit board (PCB) or an integrated circuit (IC) substrate). However, it is also possible that the component carrier structure is a coupon.

In the context of the present application, the term "coupon" (or test coupon) may particularly denote a component carrier body (such as a printed circuit board like body) which may be used to test the quality of a component carrier (in particular printed circuit board) fabrication process. Test coupons may be fabricated on the same panel as the component carriers (such as printed circuit boards), for instance at edges of the panel or even forming part of the component carriers or a region between component carriers. Coupons may then be inspected in terms of a quality test, for example to ensure proper layer alignment, electrical connectivity, etc. A coupon may also be cross sectioned to inspect internal structures. A coupon may be designed to include electrically conductive traces and vertical through connections (such as vias) with the same dimensions and structures as those of the use-type component carriers. For example, a coupon may be a strip-shaped plate (for example having dimensions of 23 x 3.5 cm²; in a modular configuration of a coupon comprising multiple individually usable coupon sections, such coupon sections may also have significantly smaller dimensions such as for example 3 x 1 cm²). Descriptively speaking, structural features of a coupon shall serve as a mirror and as a fingerprint of structural features of corresponding component carriers (such as PCBs) of the same panel. Descriptively speaking, the mirror function makes a duplicate of everything that is supposed to be checked, and the fingerprint function shows the uniqueness and displays the individual characteristics of the processes that the structural features were subjected to during manufacturing.

In the context of the present application, the term "quality test" may particularly denote an assessment of the quality of a component carrier structure by analyzing a characteristic of one or more pre-defined test targets thereof. In such a quality test, it may be tested whether or not one or more such characteristic features of the component carrier structure meet(s) one or more quality criteria. Such quality criteria may include one or more qualitative quality criteria (such as presence or absence of a delamination of a layer structure as a qualitative error pattern or failure scenario) and/or one or more quantitative quality criteria (such as a thickness of a patterned copper layer in relation to a pre-defined range of acceptable thicknesses). Examples for determinable quality defects of component carrier structures are artefacts in terms of drill holes, hair inclusions, solder resist effects, short-circuiting between electrically conductive traces to be separated, etc. For example, a quality test of the component carrier structure may be carried out to check whether the component carrier structure complies with an industrial norm (for example IPC 6012, IPC-A-600, IPC-2221, etc.).

In the context of the present application, the term "pre-defined test target" may particularly denote a structural feature in an interior of the component carrier structure, exposed by material removal, which has been pre-defined as a characteristic item for assessing a quality of the component carrier structure. For example, a test target may be a drill hole or a layer structure in a (in particular laminated) layer stack of the component carrier structure comprising at least one electrically conductive layer structure (for instance a patterned copper foil and/or a copper filled laser via) and/or at least one electrically insulating layer structure (for instance a sheet comprising resin, such as epoxy resin, and optionally reinforcing particles such as glass fibers). In particular, a characteristic or an attribute of at least one test target of the component carrier structure may comprise one or more of a diameter of a drill hole (such as a laser drill hole or a mechanical drill hole, which may or may not be filled with an electrically conductive material such as copper), a distance between adjacent drill holes, a thickness of a layer structure (in particular a thickness of a patterned copper foil or layer), a planarity of a layer structure (for instance measured by means of a deviation of a layer structure from a purely planar configuration), delamination of a layer structure (i.e. a layer structure which has detached at least partially from an integral set of for instance laminated layer structures), etc.

According to an exemplary embodiment of the invention, a fully automated system of testing quality of a component carrier structure (such as a printed circuit board coupon) is provided which can determine quality of the component carrier structure substantially without user intervention. In particular, the entire process of creating, measuring and analyzing a ground and polished component carrier structure may be carried out in an automated way. This may allow to ensure a sufficiently accurate execution of a quality test, while simultaneously achieving a high throughput on an industrial scale in terms of quality testing of component carrier structures at any stage during a manufacturing process. For this purpose, a robotic handling unit may handle the component carrier structure between some or all stages of the quality test. The component carrier structure to be tested may undergo an identification for traceability and for enabling to assign the results of the quality test to a specific component carrier structure. Furthermore, the identified component carrier structure may be subjected to a machine-controlled material removal (for example, but not limited to, abrasive material removal) process to reach a target examination plane of interest. Hence, material removal may be accomplished for exposing an interior of the component carrier structure to thereby obtain access to at least one test target (in particular a drill hole) under examination. Also in a fully automated manner, one more test targets may then be determined from the abrasively treated component carrier structure. An evaluation unit may then evaluate the results of this determination to derive a result of the quality test. Highly advantageously, none of the mentioned processes in terms of validity assessment of the component carrier structure requires any user intervention. This not only reduces human resources effort in terms of quality testing of component carrier structures, but also renders the quality test more objective, hence more meaningful and faster.

In the following, further exemplary embodiments of the method, the apparatus, the computer-readable medium, and the program element will be explained.

In an embodiment, the handling unit comprises at least one robot, in particular a multi-axis robot. For example, at least one of a linear robot, an articulated arm robot, and/or a six-axis robot or hexapod may be implemented as robot. A six-axis robot or hexapod may denote a robot with six axes equipped with sensors and being perfectly appropriate for handling component carrier structures within a fully automated apparatus cell. Hexapods may provide motion in six degrees of freedom in a compact package. In combination with absolute measuring sensors, software and motion controllers hexapods may make complicated motion profiles executable. According to an exemplary embodiment of the invention, a hexapod may be used for a material removal process (in particular a grinding process), as such a hexapod can be mechanically stable and at the same time can be adapted very precisely in six axes. Thus, target preparation supported by such a hexapod may become highly precise and at the same time more robust against possible misalignments (these can be corrected relatively easily). However, a linear robot and/or an articulated arm robot can be used for handling component carrier structures between the individual workstations of the automated apparatus.

In an embodiment, the handling unit comprises an inlet handling subunit configured for handling the component carrier structure along a sub-portion of the apparatus following the inlet, in particular between the inlet and the material removal unit. Furthermore, the handling unit may comprise an outlet handling subunit configured for handling the component carrier structure along a sub-portion of the apparatus extending up to the outlet, in particular between the material removal unit and the outlet. For instance, a first robot may be provided on the inlet side and a second robot may be provided on the outlet side of the apparatus. An interface between the first robot and the second robot may be the material removal unit.

In an embodiment, the identification unit is configured for identifying the component carrier structure based on the detection of an identifier on and/or in the component carrier structure. For instance, such an identifier may be a QR code, a barcode, an alphanumeric code, or any other optically readable code. Alternatively, the identifier may be a wireless transponder connected with the component carrier structure, for instance an RFID tag or an NFC tag. Such a transponder may be read out by a corresponding reader device of the apparatus.

In an embodiment, the identification unit is configured for identifying the component carrier structure by matching the detected identifier with correlated identity information in a database. For instance, a code derived or retrieved from the identifier of the component carrier structure may be compared with data sets in the database for obtaining more detailed identification information concerning the component carrier structure.

In an embodiment, the identification unit is configured for retrieving, in particular from a database, quality test related information and/or quality test related instructions indicative of the quality test to be carried out for the identified component carrier structure. In such a preferred embodiment, the identifier also encodes a description of the component carrier structure-specific quality test to be executed after identification. Thus, the quality test related information derived from the identifier may be supplied to a processor or control unit of the apparatus for correspondingly controlling the quality test.

In an embodiment, the determining unit is configured for processing at least one image at least of the at least one pre-defined test target detected after said material removal. In particular, the determining unit may determine the one or more test targets based on a micrograph (specifically a photomicrograph, such as a grinding surface pattern or a polished cut image) of an exposed surface plane of the component carrier structure. In the context of the present application, the term "removing material for exposing a plane" may particularly denote a material removal in a horizontal, vertical or diagonal direction of the component carrier structure. Hence, the exposed plane can have any orientation (in particular horizontal, vertical, or diagonal). For instance, a detection unit (such as a camera) may capture an image of an exposed surface of the component carrier structure after grinding and preferably polishing. Based on this image, one or more test targets which are pre-defined as particularly meaningful for the quality of the component carrier structure may then be identified at said image (for instance by automated image recognition).

In an embodiment, the apparatus comprises an inlet accommodation unit arranged at the inlet and configured for accommodating, in particular in a stacked fashion, a plurality of component carrier structures prior to testing, wherein the handling unit is configured for transferring a component carrier structure to be tested from the inlet accommodation unit through the inlet, in particular to the identification unit. Thus, all a user has to do in the context of the quality test is to stack component carrier structures to be quality tested at the inlet accommodation unit (for instance a magazine). All the rest of the quality test can then be executed in a self-sufficient way by the apparatus.

In an embodiment, the apparatus comprises an outlet accommodation unit arranged at the outlet and configured for accommodating, in particular in a stacked fashion, a plurality of component carrier structures after testing, wherein the handling unit is configured for transferring a tested component carrier structure through the outlet to the outlet accommodation unit. Hence, at the end of the quality test, the processed component carrier structures may be collected at the outlet accommodation unit (for instance a further magazine) in a stacked fashion. Thereafter, the user has again access to these quality tested samples.

In an embodiment, the apparatus comprises a removed material quantification unit configured for quantifying an amount of removed material. By collecting material removed from the component carrier structure (for instance by grinding), information concerning the progress of the material removal process can be obtained allowing to stop the material removal process when a desired test target or a previously hidden plane of interest has been exposed, preferably when a center of a drill hole has been reached.

Additionally or alternatively, other concepts of determining a progress of a material removal process (in particular a grinding progress) may be implemented as well. Examples are the detection of a changed position of an exterior edge of the component carrier structure in view of the material removal, the detection of a changed position of a material removal unit or tool impacting the component carrier structure to remove material therefrom, the detection of sensor data (for instance contact pressure and/or rotation speed) indicating an impact of the material removal unit on the component carrier structure, the detection of changes of sensor data sensed on a sacrificial structure and/or on a test target of the component carrier structure in view of the material removal, etc.

In an embodiment, the apparatus comprises a singularization (or separation) unit configured for singularizing (or separating) the component carrier structure from a larger body, in particular from a panel, before supplying the component carrier structure to the material removal unit. In particular, singularization of the component carrier structure (in particular a coupon) may be accomplished by milling or laser cutting.

In an embodiment, the apparatus comprises a thermal stress exposing unit configured for exposing the component carrier structure to thermal stress before supplying the component carrier structure to the determining unit. During ordinary use, a component carrier may be subjected to thermal stress, for instance by thermal cycling during normal operation. In order to test the quality of the component carrier structure under realistic conditions and considering thermal stress occurring during normal use, such a thermal stress may be simulated - or the component carrier structure may be subjected to such thermal stress - before determining the at least one test target and evaluating the quality of the component carrier structure on this basis.

In an embodiment, the thermal stress exposing unit is configured for exposing the component carrier structure to a thermal stress bath, in particular for floating the component carrier structure on a thermal stress bath, more particularly on molten solder. Hence, the component carrier structure may be subjected to a bath of flowable solder material for applying thermal stress to the component carrier structure in a realistic way. Highly advantageously, such a thermal stress test may be easily automated.

In an embodiment, the apparatus comprises at least one cleaning unit configured for cleaning the component carrier structure after the material removal and before the determining, in particular in an ultrasonic bath (i.e. a cleaning or rinsing bath exposed to ultrasonic sound promoting cleaning). For instance, cleaning may be carried out after material removal (preferably by grinding) and before detection of an image of the surface of the component carrier structure exposed by the material removal. Such a cleaning process after each grinding stage may improve the quality of the image and therefore the reliability and accuracy of the determination of one or more tests targets on said image. If desired or required, an additional etching process may be carried out by an etching unit after cleaning and before the optical analysis to further increase the amount of information derivable from the image and hence for increasing the identifiable amount of tests targets. In particular, copper crystal structures and plating structures may become visible by the etching.

In an embodiment, the apparatus comprises an alignment unit configured for aligning the component carrier structure before the image detection and/or before the material removal, in particular based on at least one alignment feature of the component carrier structure. Preferably, said alignment unit may comprise a multi-axis robot, most preferably a hexapod, for obtaining excellent alignment accuracy. In order to ensure a proper orientation of an exposed surface of the component carrier structure (showing the at least one test target) with respect to a camera capturing an image of exposed surface, the apparatus may automatically determine the position of one or more alignment markers of the component carrier and may adjust the position and/or orientation of the component carrier structure before capturing the image. Additionally or alternatively, prior to or during material removal for exposing said surface such an alignment process may be carried out. This improves the accuracy of the quality test.

In an embodiment, the apparatus comprises a detection unit configured for detecting image data of an interior of the component carrier structure after said removing of material. In this context, the previous interior plane of the component carrier structure being imaged by the detection unit (for instance comprising a camera) may be exposed by the prior material removal stage. The results of the image detection may then be forwarded to the determination unit for determining test targets.

In an embodiment, the determining unit is configured for determining the at least one pre-defined test target in a coarse manner based on a detected first image of the component carrier structure, and determining the at least one pre-defined test target in a refined manner based on a detected second image of the component carrier structure detected after detecting the first image. Preferably, the second image may be captured after etching a surface of the component carrier structure. Hence, the determining unit may operate in two or more stages for further enhancing the accuracy of the determined quality information. A coarse determination may be followed by a fine determination. Between different stages of determination, the analysed surface of the component carrier structure may be additionally treated (in particular by etching and/or additional grinding and/or polishing) for improving the reliability of the determination of the one or more test targets.

In an embodiment, the determining unit is configured for determining the at least one pre-defined test target by iteratively repeating a sequence comprising material removal, image detection, and optionally image evaluation. For instance, the component carrier structure may undergo a sequence of grinding, image detection, determination of a test target and optionally evaluation, before said sequence is repeated once or multiple times. Highly advantageously, a component carrier structure under analysis may undergo twice or more than two times an iteratively repeated treatment by the material removal unit, the detection unit, and the determination unit and/or evaluation unit. When determination and/or evaluation of a test target indicates that the resolution or reliability of the quality test could or should be further improved, additional material may be removed from the component carrier structure to modify the exposed surface (in embodiments, also further polishing is possible). By taking this measure, a cross-sectional plane corresponding to an exposed surface of the component carrier structure may be spatially shifted and/or tilted. Thereafter, an additional polishing process may be carried out. The correspondingly treated exposed surface of the component carrier structure may then be subjected to an additional image capturing by the detection unit, and the additionally obtained image may then be further processed by the determination unit and the evaluation unit. Iteratively, one or more issues may be identified based on an image of the exposed surface of the component carrier structure captured by the detection unit. A grinding process of the material removal unit may be adjusted in an attempt to get rid of said one or more issues (for instance to achieve compliance with an industrial standard in terms of quality testing), and results of the repeated material removal may be detected by the detection unit, and analysed by determining unit and evaluation unit. By such an iterative approach, a fully automated quality test may be carried out with high precision.

In an embodiment, the material removal unit is configured for removing material of the component carrier structure by grinding. In particular, grinding may denote an abrasive machining process that may use a grinding wheel (or another grinding body) as material removal or cutting tool. Each grain of abrasive may function as a microscopic single-point cutting edge, and shears a tiny chip from the component carrier structure. However, in other embodiments, material removal from the component carrier structure may be accomplished by other methods than grinding, for instance by laser processing or any kind of cutting.

In an embodiment, the material removal unit is configured for removing material of the component carrier structure by one of the group consisting of cross-sectional grinding and flat grinding. What concerns cross-sectional grinding, a cross section of the component carrier structure may be created that allows analysis at a plane that cuts through the plate-shaped component carrier structure. Cross-sectional grinding is a destructive technique cutting or grinding away a portion of the component carrier structure to expose an internal plane of interest for analysis. In an obtained cross section, the quality of drill holes can be assessed, the plating quality and thickness in vias can be assessed, and other test targets can be analyzed as well. As an example for such other test targets, voids in the materials of the component carrier structure may be made accessible which indicate the quality of a lamination process. What concerns flat grinding or surface grinding, such a technique may be used to produce a smooth finish on a flat surface of the component carrier structure. Flat grinding may be denoted as an abrasive machining process in which a spinning wheel (or any other body) covered with rough particles cuts chips from a main surface of the component carrier structure thereby accessing a main surface of an interior layer of the component carrier structure.

In an embodiment, the apparatus comprises a polishing unit configured for polishing an exposed surface of the component carrier structure after removing material. Polishing may denote the process of creating a smooth surface by rubbing it or using a chemical action, leaving a surface with a reduced roughness. In contrast to grinding, polishing does not remove a noteworthy amount of material from the surface of the component carrier structure, but simply enhances planarity by flattening the surface. Polishing may use multiple stages, starting with a rougher abrasive, wherein each subsequent stage may use a finer abrasive.

In an embodiment, the apparatus comprises an encapsulation unit configured for encapsulating the component carrier structure in an encapsulant so that the component carrier structure is subjected to detection and/or determination in the encapsulant. For example, the component carrier structure may be embedded in a matrix of resin for simplifying handling thereof during processing and/or detection. Such an encapsulation process may be automated and may also function as a stress buffer protecting the component carrier structure.

In another preferred embodiment, the determining unit is configured for determining the at least one pre-defined test target based on a non-encapsulated component carrier structure. Correspondingly, the method may comprise detecting an image of and/or determining the at least one pre-defined test target based on a non-encapsulated component carrier structure. Highly advantageously, the automated apparatus does not necessarily require encapsulation of the component carrier structure (such as a coupon) before optical inspection. Omitting an encapsulation and inspecting a non-encapsulated component carrier structure may significantly simplify and accelerate the automated quality test.

In an embodiment, the evaluation unit is configured for evaluating a quality of the component carrier structure based on properties of the determined at least one test target. For instance, a desired range of properties of parameters of each test target may be pre-defined (and for example stored in a database). For each test target and corresponding properties (for instance a diameter of a drill hole) of the analysed component carrier structure, it may be assessed by the evaluation unit whether or not a respective test target complies with the requirements of the desired pre-defined properties.

In an embodiment, the evaluation unit is configured for evaluating the quality by classifying the component carrier structure into one of a plurality of quality classes, in particular in one class of a group of classes consisting of "pass", "fail", and "further analysis required". Classifying a component carrier structure as "pass" means that the analysed one or more test targets of the component carrier structure indicate a satisfactory quality of the component carrier structure, and that the component carrier structure (and in particular assigned component carriers) may proceed for intended use. Classifying a component carrier structure as "fail" means that the analysed one or more tests targets of the component carrier structure indicate an insufficient quality of the component carrier structure, and that the component carrier structure (and in particular assigned component carriers) are considered as waste or defective product. If the evaluation concludes that on the basis of the available data no sufficiently reliable conclusion can be drawn, the apparatus may output a corresponding indication and may for instance propose or carry out an additional automated analysis or may propose a human user based assessment. Such a classification of each tested component carrier structures into one of multiple predefined groups may simplify automated execution of the quality test. For instance, one or more of the criteria mentioned in chapter "3.6 Structural Integrity" of IPC-6012D (version: September 2015) may be considered for evaluating a defect.

More specifically, the evaluation unit may be configured for evaluating the quality by classifying each test target of the component carrier structure into one of a plurality of quality classes, in particular in one class of a group of classes consisting of "pass", "fail", and "further analysis required". Advantageously, each characteristic, attribute or parameter of a test target to be examined may be classified in this way. The final decision may be made as described in the preceding paragraph, but the judgement concerning the individual characteristics, attributes or parameters may form the basis of such a quality decision. In the event of only slight deviations of less critical parameters it can be decided that a component carrier structure can be evaluated with "pass". Criteria as a basis for such a decision may be predefined by a user or by a specification indicative of quality.

In an embodiment, the evaluation unit comprises an artificial intelligence module configured for carrying out the evaluation using artificial intelligence, in particular machine learning, more particularly a neural network. In the context of the present application, the term "artificial intelligence" may particularly denote tools such as neural networks, self-learning or self-adaptive systems, fuzzy logic, etc. Artificial intelligence may operate independently of human beings on the basis of electronic hardware and software resources. Correspondingly, an artificial intelligence module may be a physical or a virtual entity including artificial intelligence capabilities. Artificial intelligence may particularly denote the implementation of algorithms and/or statistical models that a processor (such as a computer system) may use to perform a specific task without using explicit instructions, relying on patterns, or the like. In particular, artificial intelligence algorithms may build a mathematical model based on input data (which may also be denoted as training data) in order to make predictions or decisions without being explicitly programmed to perform the task. In an embodiment, processing by the artificial intelligence module comprises processing by deep learning. Deep learning may particularly denote machine learning methods based on artificial neural networks with representation learning. Deep learning can be supervised, semi-supervised or unsupervised. Examples of deep learning architectures, which may be implemented according to exemplary embodiments of the invention, are deep neural networks, deep belief networks, recurrent neural networks and convolutional neural networks. The implementation of deep learning algorithms in the automatic execution of a quality test, in particular in terms of interpretation of pre-determines test targets concerning quality of the component carrier structure, may further improve the reliability, performance and accuracy of the quality test. In an embodiment, processing by the artificial intelligence module comprises processing by a neural network. Such a neural network may be a computing system which may be capable of learning to perform tasks by considering examples, generally without being programmed with task-specific rules. A neural network may be based on a collection of connected nodes called artificial neurons. Each connection between said neurons can transmit a signal to other neurons. An artificial neuron that receives a signal then processes it and can signal neurons connected to it. During learning, the weights of the connections may be continuously adjusted. By inputting the previously determined test targets of the component carrier structure under analysis, the neural networks can contributes to assess quality of the component carrier structure.

In an embodiment, the apparatus is configured for carrying out the quality test without human intervention between the inlet and the outlet. Correspondingly, the method may comprise carrying out the quality test without human intervention between the inlet and the outlet. This avoids human errors and increases the throughput.

In an embodiment, the component carrier structure comprises a stack of at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier structure is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier structure is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through holes through the laminate, for instance by laser drilling or mechanical drilling, and by filling them with electrically conductive material (in particular copper), thereby forming vias or other through hole connections. The (for instance partially) filled hole may connect the whole stack (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers) or other reinforcing particles (such as reinforcing spheres, in particular glass spheres).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal, and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylether PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials (wherein "DK" may refer to the real part of the dielectric constant) may be applied in the component carrier as electrically insulating structures.

In an embodiment, the at least one electrically conductive layer structures comprises at least one of the group consisting of copper, aluminum, nickel, silver, gold, palladium, and tungsten. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component, which can be embedded in the stack, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay could be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such as solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), gold (in particular Hard Gold), chemical tin, nickel-gold, nickel-palladium, Electroless Nickel Immersion Palladium Immersion Gold (ENIPIG), etc.

The aspects defined above and further aspects of the invention are apparent from the examples of embodiment to be described hereinafter and are explained with reference to these examples of embodiment.
Figure 1 illustrates a flowchart of a method of carrying out a quality test of a component carrier structure according to an exemplary embodiment of the invention.
Figure 2 schematically illustrates an apparatus for carrying out a quality test of a component carrier structure according to an exemplary embodiment of the invention.
Figure 3 illustrates details of an apparatus for carrying out a quality test of a component carrier structure according to an exemplary embodiment of the invention.
Figure 4 illustrates a process flow of a method of carrying out a quality test of a component carrier structure according to an exemplary embodiment of the invention.
Figure 5 illustrates an automated cell of an apparatus for carrying out a quality test of a component carrier structure according to an exemplary embodiment of the invention.

The illustrations in the drawings are schematic. In different drawings, similar or identical elements are provided with the same reference signs.

Before referring to the drawings, exemplary embodiments will be described in further detail, some basic considerations will be summarized based on which exemplary embodiments of the invention have been developed.

According to an exemplary embodiment of the invention, a full automation of the execution of a quality test of the component carrier structure such as a coupon is made possible. In particular, such an automated system may combine all single processes in a fully automated quality test cell by using standardized component carrier structure samples and automated measurement/inspection techniques. As a result, a high throughput and a high accuracy in terms of target preparation may be obtained. Automated measurement and visual inspection of component carrier structure samples may be made possible by implementing elements of artificial intelligence. Highly advantageously, an unbiased assessment of component carrier structure may be made possible. By such an automated apparatus, an improved capability and capacity for laboratory inspections may be achieved. Furthermore, an increased automation level, repeatability and throughput may be achieved as well. In particular, an automated system for carrying out a quality test on a component carrier structure may enable a high speed and high accuracy inspection of component carrier structures, in particular compliant with a Conformance Test Coupon according to Chapter 12.1 of IPC-2221B (version: November 2012).

Examples for variables having an influence on cross-sectioning of component carrier structures (see a more detailed discussion of the individual variables below) are a grinding body used for material removal, alignment (for instance making use of a handling arm), pressure applied during grinding and/or polishing, rotation speed during grinding and/or polishing, control in particular of a material removal from a component carrier structure (more specifically material removal progress control), cleaning (of component carrier structure and/or grinding body) to avoid carryover, heating or cooling, and thermal and mechanical loads.

What concerns grinding, adjustable parameters are grain size, contact pressure, and rotation speed of abrasive medium. Grain may also be adjusted for a grinding machine. Polishing of a cross-sectional surface of the component carrier structure may be carried out using a diamond suspension (wherein rotation may be synchronized or reciprocal). Optionally, immersion and/or filling of a component carrier structure may be possible to prevent smearing of copper holes.

With respect to a used grinding body for material removal, it may be advantageous that the material removal process does not generate excessive heat to keep the laminate of the component carrier structure intact. Preferably, the material removal process may be carried out at a temperature significantly below the glass transition temperature Tg (for example at least 10% below Tg on the Celsius scale or on the Kelvin scale) of the resin material of the component carrier material. For example, water can be used as a cooling and/or cleaning medium.

For removing material of the component carrier structure, grinding may be preferred. However, material removal can also be accomplished by (for instance wire) cutting, wire eroding, plasma treatment, laser treatment, sandblasting, water jetting, milling, sawing, treatment by gate shears, ion beam treatment and/or punching.

Preferably, the grain size may be (in particular at the end of the material removal) fine enough that subsequent polishing is supported. Grain size may be selected depending on a used polishing suspension. For example, 3 µm grains may be applicable for only a certain degree of grinding.

In order to suppress a variance of planarity of a ground and/or polished surface of the component carrier structure, it may be advantageous to avoid excessive heat and cold. Furthermore, thermal and mechanical loads should be kept low.

When designing a handling arm of the handing unit, slipping and/or turning of the component carrier structure should be kept as low as possible. This advantageous boundary condition may influence the choice of a maximum rotation speed.

Next, embodiments of the grinding process will be explained. Advantageously, an iterative grinding control process may be carried out. Grinding disks (or plates) may be arranged horizontally or vertically, or at a special angle if required or desired (in view of an implemented type of grinding).

What concerns the control of a progress of the material removal, a camera may be used for monitoring grinding progress. For instance, such a camera may be arranged on and/or in a grinding body. This may promote planarity and/or alignment of the treated surface of the component carrier structure. Progress control may also be accomplished by an electric measurement, for instance by contacting a copper structure which is removed partially or entirely at a certain material removal progress state, which can be detected by a change of an electric signal. Additionally alternatively, progress control may be based on one or more mechanical stops (for instance having a sufficiently hard surface, preferably a diamond surface), against which a grinding body abuts when a predefined progress of the material removal process is achieved. Also a resistance measurement on a grinding body may be used for progress control. In other embodiments, progressive feed may be measured in terms of progress control. For example referring to a through hole, the moment that such a hole is opened may result in a significant pressure drop. When a micro via is reached, the impact on pressure may be the other way around, i.e. a pressure increase, or resistance increase may be detected. Grinding metallic via material rather than softer resin material may increase the pressure. If an electric signal is measured at the micro via and the electrically conductive material of the micro via is removed, the electric resistance may increase, which may be detectable as well. In yet another embodiment of progress control, discoloration for instance of water upon target achievement may be detected. Also a resistance measurement (for instance of a sacrificial structure removed during grinding) may be used for progress control. In yet another embodiment relating to progress control, sound detection, tribometer-based detection, a pin pressing on a grinding disc (optionally combined with a light barrier), etc., may be used. Once a center of a drill hole is detected, then grinding may stop.

Preferably, progress can be measured at or close to a test target. Still referring to progress control of a grinding process, a hard stop may be possible. However, also iterative grinding processes are possible.

In an embodiment, contact pressure between grinding body and component carrier structure may be measured. For instance, this may be accomplished in an automated manner by a pressure regulator (regulating for instance depending on force). During material removal, the pressure can remain constant or may be varied. A smaller number of grinding bodies can be balanced with time, pressure, rotation. It may also be possible to apply a variable pressure depending on throughput, quality target, sample thickness. Maximum pressure may be regulated in such a way that no damage of the component carrier structure occurs, in particular at or around test targets such as drill holes. In particular, the contact pressure can be selected depending on how the component carrier should be ground (for instance grinding along layers, grinding against layers, etc.). Care should be taken that cutting preparation neither enhances nor reduces quality problems in the component carrier structure.

What concerns rotation speed and type, it may be advantageous to generate heat only in a range below a predefined maximum value. A rotation direction may be synchronized or may be opposite. A gripping or handling device (such as a clamping device, a handling fixture, a hexapod, etc.) can oscillate quickly.

Parameters which can be adjusted in terms of rotation are rotation time, contact pressure, type of rotation, material of the component carrier structure, grain, etc.

Concerning alignment or orientation of the component carrier structure during its treatment for carrying out the quality test in an automated way, a camera may determine whether the component carrier structure sample is positioned correctly before a first grinding. If necessary, the position of the component carrier structure may be corrected to ensure a proper alignment (for instance based on a comparison with external reference holes that are preferably not coppered; such reference holes may for instance be drilled or etched in a photo process). Alternatively, a mechanical alignment process (for instance using an alignment pin) may be carried out.

An objective of the alignment may be that a target plane and a grinding medium should be oriented in parallel. This may be achieved by correspondingly influencing medium, grinding body, turning one or even all of the involved components, etc.

Still referring to alignment, a camera image may capture reference points and target points to be viewed. Such data may define a target plane (software-supported, mechanically, etc.) and may bring a target plane parallel to the grinding medium. In the further course of alignment control, limiting factor may be the combination of hexapod/grinding speed/maximum force, so that the alignment remains which corresponds to the mechanical stability of the overall system.

Now referring to cleaning of the component carrier structure, one embodiment may clean the component carrier structure during grinding. In an iterative approach, each new grinding stage (for instance fine grinding following coarse grinding) may be preceded by a cleaning stage. Cleaning may ensure that no carryover of particles takes place. For instance, particles may be blown away, sucked away, evaporated, burnt, stripped off, brushed, rinsed, etc., in terms of cleaning. For instance, continuous cleaning may be carried out during the grinding process. Suction, rinse (preferably bath or sink), strip off, blow away, ultrasonic bath (shake out) or other cleaning units may be implemented. Advantageously, very small cracks may be rinsed out by cleaning. After cleaning, it may be advantageous that the remaining particles should be at the maximum equal in size to or smaller in size than the grain size used for grinding in the next process.

What concerns coupon design, it may be standardized, or may deviate. Any deviation may be coordinated with a user. For instance, a coupon-type component carrier structure may be provided with one or more registration holes, a wear sensor, etc.

Examples for quality criteria or characteristics in terms of assessing quality of a component carrier structure are a sharp edge (preferably 90°), a radius near zero, planarity, a tolerance below a predefined threshold value (for instance 10% or preferably less than 10%, having a tolerance of not more than 7%). A further quality feature of a component carrier structure is that it is should be preferably scratch-free in an image at 100x magnification. Furthermore, the component carrier structure should be free of gaps (in particular between sample and embedding agent, more particularly between conductive layer and embedding agent, especially between copper and embedding agent). Resins may shrink when embedding (fast curing embedding agents have a lot of volume loss, slow curing agents have little volume loss), but shrinkage should not be excessive.

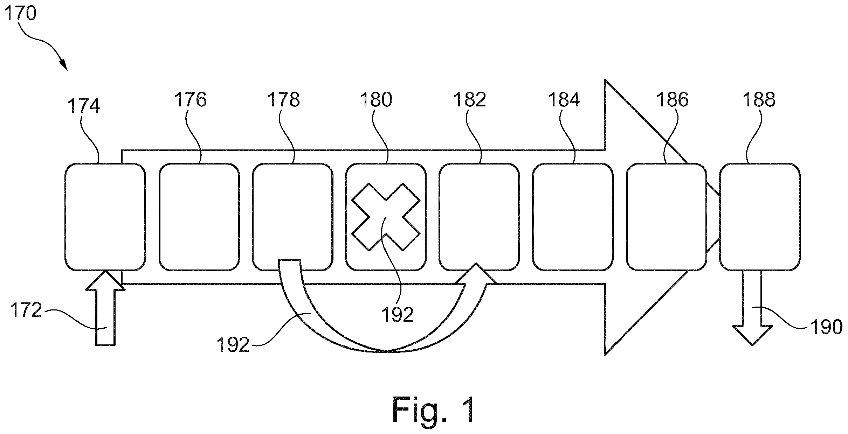

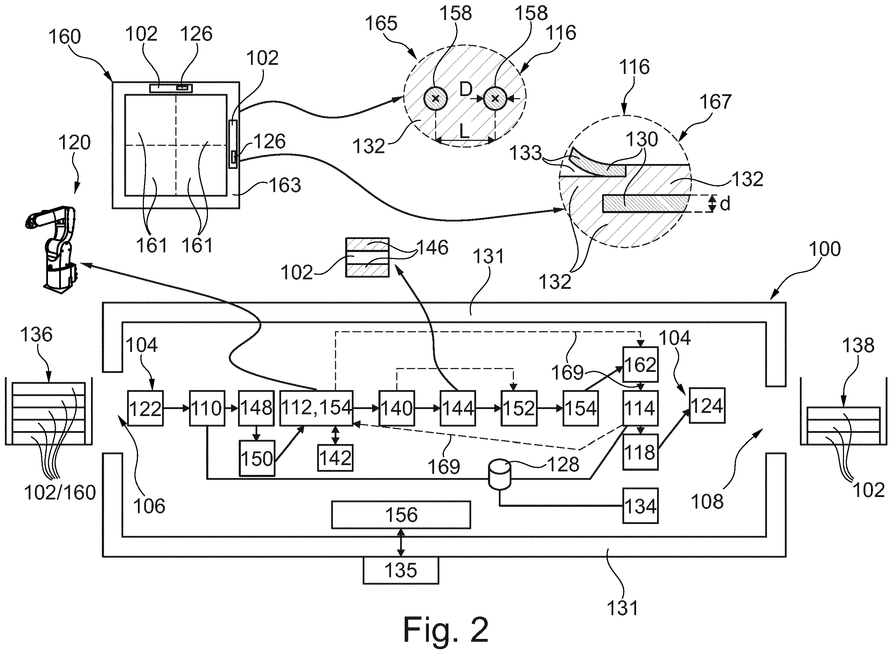

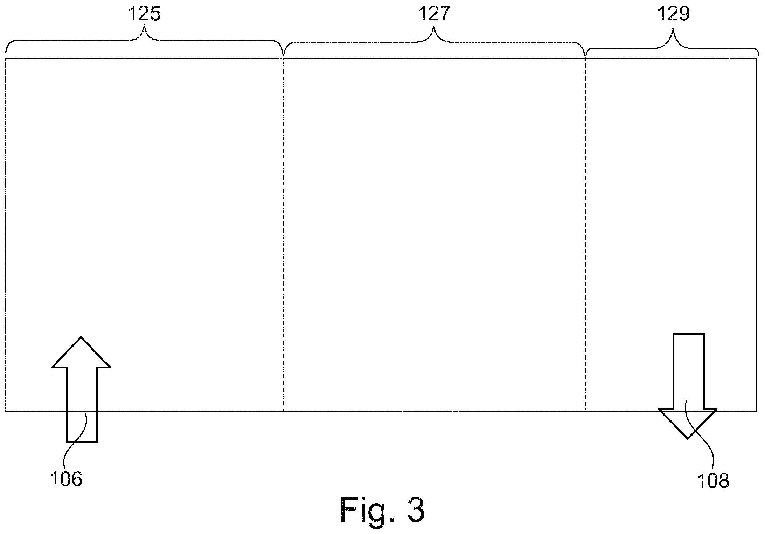

**Figure 1** illustrates a flowchart 170 of a method of carrying out a quality test of a component carrier structure 102 according to an exemplary embodiment of the invention. The reference signs used for the description of Figure 1 refer to the embodiments of Figure 2 or Figure 3. Preferably, the mentioned component carrier structure 102 may be a coupon forming part of a panel and used for testing component carriers (such as printed circuit boards (PCBs) or integrated circuit (IC) substrates). However, the component carrier structure 102 may be alternatively a panel or an array (such as a quarter panel) comprising multiple connected preforms of component carriers, or a preform of a component carrier or a readily manufactured component carrier.

Advantageously, the method of flowchart 170 may correspond to the execution of a quality test of the component carrier structure 102 by an automated apparatus 100. Preferably, the method may comprise carrying out the quality test without human intervention between an inlet 106 - corresponding logically to input 172 - and an outlet 108 - corresponding logically to output 190 - of said apparatus 100. In other words, inlet 106 of apparatus 100 corresponds to input 172 of the method, whereas outlet 108 of apparatus 100 corresponds to output 190 of the method. More specifically, an automated process for cross section preparation and visual inspection as well as measurement of a component carrier structure 102 is provided. Preferably, no manual work occurs, and the entire process may be automated. For this purpose, the test coupon-type component carrier structure 102 may be configured for automated handling and for machine-readable serialization.

As indicated with reference sign 172, the component carrier structure 102 may be input into apparatus 100.

Referring to a block 174, a coupon may be inserted as component carrier structure 102 into the apparatus 100 and may hereby be handled fully automatically by a robot 120. More specifically, the coupon may be a component carrier structure 102 which may for example be constructed or designed in accordance with IPC-2221. The component carrier structure 102 may provide traceability information to the apparatus 100. For this purpose, the method which may be carried out using apparatus 100 may comprise automatically identifying the component carrier structure 102 which shall undergo the quality test. For instance, it may be possible to register the coupon-type component carrier structure 102 in a list. Multiple coupons may be sorted. For traceability purposes, it may be possible to assign information such as lot number, panel number, array number, x/y information, cross section number, a report number, a request identifier, etc., in a data set assigned to a respective component carrier structure 102. For instance, such data sets may be stored in a database 128.

Referring to a block 176, the component carrier structure 102 which may still be integrally connected with the rest of a panel or the like may be singularized or separated, for instance by milling or cutting the component carrier structure 102 out from a larger body 160 such as a panel. For this purpose, it may be possible to search a defined position of the component carrier structure 102 in the larger body 160 and cut it out. As a result, a test sample in form of the separated component carrier structure 102 may be obtained. For instance, cutting out the component carrier structure 102 may be accomplished in accordance with a smallest plated through hole or corresponding to a user definition.

Referring to a block 178, the component carrier structure 102 may then be subjected to thermal stress, for instance by executing a solder float test. For example, the component carrier structure 102 may be immersed in molten solder for subjecting thermal stress to the component carrier structure 102. As an alternative to a solder float test, it may also be possible to carry out an alternative thermal stressing method, e.g. reflow simulation.

Referring to a block 180, the component carrier structure 102 may or may not be subjected to an encapsulation process for simplifying handling and/or for buffering stress during the subsequent quality test. While conventional manual quality tests of component carrier structures may require encapsulation before assessing quality, such an embedding may be omitted according to an exemplary embodiment of the invention involving a fully automatic quality test of the component carrier structure 102. If carried out optionally, the encapsulation process may put the component carrier structure 102 into embedding material, such as resin, for further preparation. However, such an embedding can be advantageously skipped (as indicated with reference sign 192) in other embodiments, since automated handling according to an exemplary embodiment of the invention can also be accomplished without such an encapsulation.

Referring to a block 182, it may then be possible to remove material of the component carrier structure 102 for exposing an interior of the component carrier structure 102 to be subjected to the quality test. More specifically, a microsection (in particular cross-section) of the component carrier structure 102 may be created. For this purpose, the component carrier structure 102 may be ground and subsequently polished up to a defined position (preferably up to a center of a via or drill hole or a pattern). For instance, different stages of sandpaper treatment and polishing may be carried out. For grinding, it may for instance be possible to use sandpaper with different grains (for instance using one or more of the following grains: 60, 180, 1200, 2000).

Referring to block 184, the method may then comprise determining one or more pre-defined test targets 116 (such as plated vias and their properties) of the component carrier structure 102 after said material removal. Furthermore, the method may comprise evaluating characteristics or attributes of the one or more test targets 116 of the component carrier structure 102 for assessing the quality of the component carrier structure 102. When skipping block 180, the method may comprise determining the at least one pre-defined test target 116 based on a non-encapsulated component carrier structure 102, otherwise based on an encapsulated component carrier structure 102. In particular, a visual analysis of the cross-section of the component carrier structure 102 may be carried out, preferably in an automated way. For example, x/y dimension measurements may be carried out (for instance inspecting a build-up, a copper thickness, etc.). In particular, the visual check may include an analysis of certain defects. During said inspection, one or more of the following test targets 116 and assigned characteristics may be considered: multilayer build up; plated through hole properties (like wall properties, land characteristics); quality of surface roughness (for instance, surface roughness may be determined corresponding to the Ra scale and/or corresponding to the Rz scale). In terms of roughness, the roughness value Rz may be used as a criterion for the presence of scratches at an exposed surface (in particular a cross-section) of the component carrier structure 102, whereas the roughness value Ra may be used as a criterion for the quality of the material removal process (in particular grinding process). For instance, a quality criterion may be that the roughness of a surface of the component carrier structure 102 exposed by grinding and/or polishing should not be larger than the roughness of a grinding disc and/or polishing paste used in a preceding material removal stage. If this criterion was not fulfilled, it may be concluded that an artifact has been introduced by an earlier material removal stage. For instance, a measurement resolution of at least 1 µm may be obtained. For example, a quality test may be carried out in accordance with IPC-6012, IPC-A-600, etc.

Referring to block 186, the method may comprise creating and storing a report with pre-defined properties. The report may summarize the quality test and its conclusions. This may ensure a proper documentation of the quality test.

Referring to block 188, the method may then comprise archiving the analyzed component carrier structure 102 and the quality test. In particular, this may involve sample storage, storage of electronic documentation, etc.

As indicated with reference sign 190, the component carrier structure 102 may then be output from the apparatus 100.

**Figure 2** schematically illustrates an apparatus 100 for carrying out a quality test of a component carrier structure 102, here embodied as a coupon, according to an exemplary embodiment of the invention. As indicated by a circumferential casing 131 of the apparatus 100, the entire quality test can be carried out in an automated manner within a closed cell.

On the top left-hand side of Figure 2, a plan view of a planar sheet-like body 160 is illustrated, which can be a panel for manufacturing a plurality of component carriers (such as printed circuit board) in a batch procedure. The illustrated panel may for instance have a dimension of 18 x 24 inch² or more. A central main area of the panel may be subdivided into multiple arrays 161 (four quarter panels in the shown embodiment), each comprising multiple PCBs. In a frame 163 surrounding the component carriers, one or more strip-shaped test coupons may be formed as component carrier structures 102. Advantageously, at least one horizontally extending component carrier structure 102 and at least one vertically extending component carrier structure 102 may be foreseen, so as to make it possible to carry out the quality test to identify potential structural defects in two perpendicular directions.

Referring now to apparatus 100 in further detail, an inlet accommodation unit 136 is arranged at an inlet 106 of said apparatus 100 and is configured for accommodating a plurality of component carrier structures 102 in a stacked fashion prior to testing. Hence, the coupon-type component carrier structures 102 may be inserted into the inlet accommodation unit 136 after separation from panel-type body 160. Alternatively, it is possible to stack the larger bodies 160 each including at least one component carrier structure 102 in the magazine-type inlet accommodation unit 136.

A robotic handling unit 104 is configured for handling the component carrier structure 102 (optionally still connected within body 160) along various portions between the inlet 106 and an outlet 108 of the apparatus 100. In particular, the handling unit 104 is configured for gripping and transferring the component carrier structure 102 to be tested (or the entire body 160) from the inlet accommodation unit 136 through the inlet 106 to a below described identification unit 110. More specifically, the handling unit 104 comprises an inlet handling subunit 122 configured for handling the component carrier structure 102 between the inlet 106 and a below described material removal unit 112. Advantageously, the handling unit 104 comprises one or more robots 120 which may comprise one or more hexapods, one or more linear robots, one or more articulated arm robots, etc. A six-axis robot or hexapod (schematically illustrated in Figure 2 at reference sign 120) may have axes equipped with sensors and being appropriate for handling component carrier structures 102 within fully automated apparatus 100. Advantageously, a hexapod may be used for a material removal process (in particular a grinding process) carried out by material removal unit 112, as such a hexapod can be mechanically stable and at the same time can be adapted very precisely in six axes. Referring to Figure 3, a six-axis robot or hexapod may be used in cross-sectional station 127 for operating material removal unit 112 and/or for operating alignment unit 154. Consequently, preparation of the component carrier structure 102 by material removal may become highly precise and robust against possible misalignments. Furthermore, a linear robot and/or an articulated arm robot (not shown) of inlet handling subunit 122 and/or at outlet handling subunit 124 of handling unit 104 can be used for handling component carrier structures 102 between the individual workstations of the automated apparatus 100.

As already mentioned, the inlet handling subunit 122 of the handling unit 104 forwards the component carrier structure 102 to the identification unit 110. The latter is configured for identifying the component carrier structure 102 for which the quality test shall be carried out. This may ensure traceability. More specifically, the identification unit 110 is configured for identifying the component carrier structure 102 based on the detection of an identifier 126 which may be physically connected to or which may form an integral part of the component carrier structure 102. For instance, such an identifier 126 may be a QR code, a barcode or an alphanumeric to code which can be read out by an optical reader of the identification unit 110. It is also possible that the identifier 126 is a transponder such as an RFID (radiofrequency identification) tag or an NFC (near field communication) tag. In such embodiments, the identification unit 110 may comprise a wireless reader configured for wirelessly reading out the transponder-type identifier 126 for retrieving identification information. For identifying the component carrier structure 102 based on its identifier 126 and/or for retrieving additional data (for instance specific quality test instructions) assigned to the identified component carrier structure 102, the identification unit 110 may access a corresponding database 128. In particular, the identification unit 110 may be configured for identifying the component carrier structure 102 by matching the detected identifier 126 with correlated identity information which is stored in an assigned data set in said database 128. For instance, such a data set may correlate an identification code readable from the identifier 126 with further information concerning the component carrier structure 102, for instance information concerning its manufacturing history (such as lot number, manufacturing date, manufacturing time, etc.). The identification unit 110 may also be configured for retrieving from the database 128 quality test related information indicative of the quality test to be carried out for the identified component carrier structure 102. Such quality test related information may define a quality test which shall be carried out for the identified component carrier structure 102. Different quality tests may be carried out for different types of component carrier structures 102.

In an embodiment in which the component carrier structure 102 has not yet been separated from the larger body 160 before introducing the component carrier structure 102 through inlet 106 into the apparatus 100, a singularization unit 148 (such as a milling machine or a laser cutter) may be provided and may be configured for singularizing the component carrier structure 102 from the panel-type body 160. For instance, singularization may be accomplished by milling or laser cutting.

Thereafter, the processed component carrier structure 102 may be conveyed by the handling unit 102 to a thermal stress exposing unit 150 configured for exposing the component carrier structure 102 to thermal stress. Preferably, the thermal stress exposing unit 150 is configured for floating the component carrier structure 102 on a thermal stress bath, which may comprise molten solder. Thereby, thermal stress may be subjected to the component carrier structure 100.

The component carrier structure 102 may then be forwarded by the above-mentioned or by another robot 120 of the handling unit 104 to a material removal unit 112. The latter is configured for removing material of the component carrier structure 102 for exposing an interior of the component carrier structure 102 undergoing or subjected to the quality test. In particular, the material removal unit 112 may be configured for removing material of the component carrier structure 102 by grinding, preferably cross-sectional grinding (or alternatively flat grinding).

For improving the precision of the material removal, the component carrier structure 102 may be aligned by an alignment unit 154 which may for instance be configured for determining an alignment marker (for instance a drill hole) of the component carrier structure 102 based on a captured image thereof). Said alignment may be carried out prior to grinding by material removal unit 112. Alignment unit 154 is assigned to the material removal unit 112 and may be configured for aligning the component carrier structure 102 before the material removal process. Hence, an alignment carried out by alignment unit 154 is preferably carried out before the material removal process executed by material removal unit 112. Such an alignment may thus form part of the material removal process, in particular grinding process.

Optionally, a removed material quantification unit 142 may be provided and configured for quantifying an amount of material removed from the component carrier structure 102 during grinding. By determining the amount of ground material, a grinding progress and hence a precise control of the grinding process may be made possible.

After grinding, the component carrier structure 102 may be supplied to a polishing unit 140 configured for polishing an exposed surface of the component carrier structure 102 after removing material. Rather than removing an additional substantial amount of material from the component carrier structure 102 (which occurs during grinding), polishing may reduce surface roughness and may improve surface quality without excessive material removal. A polished surface may provide more or more precise information concerning one or more tests targets 116 used as target features to be analysed in the following.

Only optionally, the component carrier structure 100 may then (or alternatively already before material removal by material removal unit 112) be supplied to an encapsulation unit 144 configured for encapsulating the component carrier structure 102 in an encapsulant 146 so that the component carrier structure 102 is to be detected subsequently in the encapsulant 146. Such encapsulant 146 may be a resin functioning as a stress buffer and simplifying handling of the component carrier structure 102 during a subsequent (and/or during a previous) analysis.

However, it may be alternatively possible and even preferred that such an encapsulation is omitted, since the fully automated quality test apparatus 100 may also be capable of carrying out the quality test of the component carrier structure 102 without encapsulation. Thus, even a non-encapsulated component carrier structure 102 may be subjected to the subsequent processes.

Thereafter, the (encapsulated or non-encapsulated) component carrier structure 102 may be forwarded, for instance by a further robot 120 of the handling unit 104, to a cleaning unit 152 configured for cleaning the component carrier structure 102. For instance, the component carrier structure 102 may be rinsed in an ultrasonic bath.

A further alignment unit 154 may be configured for aligning the component carrier structure 102 before detecting and determining tests targets 116 thereon. For this purpose, one or more alignment features (such as through holes, for instance arranged in corners) of the component carrier structure 102 may be detected and used for spatially aligning the component carrier structure 102.

The aligned component carrier structure 102 may then be imaged. For this purpose, a detection unit 162 may be provided and configured for detecting image data of a (meanwhile exposed by said material removal) interior of the component carrier structure 102.

Such image data may be transmitted to a determining unit 114. The latter may be configured for determining one or more pre-defined test target 116 of the component carrier structure 102. The test targets 116 may be predefined features visible in the imaged cross-section of the component carrier structure 102 and may relate to specifically meaningful features in terms of quality evaluation. Appropriate characteristics or attributes of test targets 116 of the component carrier structure 102 may be a diameter D of a drill hole 158 (in particular a laser drill hole or a mechanically drilled hole, which may be filled by plated copper), a distance L between such adjacent drill holes 158, a thickness d of an electrically conductive layer structure 130 (such as a patterned copper layer) and/or of an electrically insulating layer structure 132 (such as a sheet of prepreg), a planarity of a such a layer structure 130 and/or 132, and a degree of delamination (see reference sign 133) of such a layer structure 130 and/or 132. The mentioned test targets 116 are illustrated in Figure 2 in a top view 165 and in a side view 167, respectively. However, another test target 116 (for instance in the scenario of flat grinding) may be a copper line or a plurality of copper lines and a space in between.

Advantageously, the determining unit 114 is configured for processing the image data for determining or recognizing the pre-defined test targets 116. More specifically, the determining unit 114 may be configured for firstly determining the pre-defined test targets 116 in a coarse manner based on a detected first image of the component carrier structure 102. Moreover, the determining unit 114 may be configured for secondly determining the pre-defined test targets 116 in a refined manner based on a detected second image of the component carrier structure 102 detected after detecting the first image and after etching a surface of the component carrier structure 102. In an alternative embodiment, a one-shot operation of the determining unit 114 may be possible as well, in which the determining unit 114 determines test targets 116 based on a single image. As a basis for the determination, the determination unit 114 may also have access to database 128, for instance to get access to test targets 116 to be considered for the determination.

Highly advantageously and as indicated by a feedback loop 169, the determining unit 114 may be configured for determining the pre-defined test target(s) 116 by iteratively repeating a sequence comprising material removal (optionally including polishing and/or cleaning and/or etching), image detection, and image analysis. By such an iterative approach (which can be terminated when a sufficient accuracy is achieved), the reliability of the quality test may be significantly improved.

As further shown in Figure 2, an evaluation unit 118 is provided which is configured for evaluating the determined test target(s) 116 of the component carrier structure 102 for assessing the quality of the component carrier structure 102. The evaluation unit 118 may be advantageously configured for evaluating a quality of the component carrier structure 102 based on properties of the determined test target(s) 116. More specifically, the evaluation unit 118 may be configured for evaluating the quality by classifying the component carrier structure 102 into one of a plurality of quality classes. Highly appropriate may be an automated classification of a respective component carrier structure 102 (and/or an assigned larger body 160) in one class of a group of classes consisting of "pass" (indicating that the component carrier structure 102 and/or the larger body 160 has/have passed the quality test), "fail" (indicating that the component carrier structure 102 and/or the larger body 160 has/have not passed the quality test), and "further analysis required" (indicating that the component carrier structure 102 and/or the larger body 160 need additional quality analysis, since the evaluation unit 118 is not yet in a position to decide in a meaningful way about the quality). In the latter case, it may also be possible to convey the component carrier structure 102 to a human operator for human analysis. The described communication and user impact can be exchanged between the user and the apparatus 100 by an input/output unit 135 being communicatively coupled with control unit or processor 156.

In particular, the evaluation unit 118 may be configured for evaluating the quality by classifying each test target 116 individually or preferably each attribute or characteristic of each test target 116 of the component carrier structure 102 individually into one of a plurality of quality classes, in particular in one class of a group of classes consisting of "pass", "fail", and "further analysis required". Only slight deviations of uncritical parameters may still allow to classify a component carrier structure 102 as "pass". A defect may be classified as critical or uncritical based on a type of a specific defect and/or based on the intensity of a specific defect. Such a quality test may comprise multiple criteria, which may be judged individually to enable fine-gained decisions on quality and performance.

For supporting its evaluation tasks, the evaluation unit 118 may comprise an artificial intelligence module 134 configured for carrying out the evaluation using artificial intelligence, for instance making use of a neural network. Training data, etc., for training the artificial intelligence module 134 may also be stored in database 128.

By an optional etching process of etching the exposed surface of the component carrier structure 102, additional features on the analysed exposed surface of the component carrier structure 102, such as grain boundaries and plating lines, may become visible. This may render the evaluation of the characteristics of the test targets 116 by the evaluation unit 118 even more accurate.

After said evaluation, the analysed component carrier structure 102 may be transported out of the apparatus 100. For this purpose, the handling unit 104 is provided with an outlet handling subunit 124 configured for handling the component carrier structure 102 by means of at least one additional robot 120, for instance between the material removal unit 112 and the outlet 108. As shown, the apparatus 100 comprises an outlet accommodation unit 138 (for instance also of a magazine-type) arranged at the outlet 108 and configured for accommodating a plurality of component carrier structures 102 in a stacked fashion after testing. The handling unit 104 may be configured for transferring a tested component carrier structure 102 through the outlet 108 to the outlet accommodation unit 138. This may be accomplished for example by further robot 120.

As indicated with reference sign 156, the apparatus 100 may comprise one or more processors or a part of a processor which may be considered as a control unit for controlling operation of the apparatus 100 and its above-described constituents during the quality test of the component carrier structure 102.

Highly advantageously, the apparatus 100 may be configured for carrying out the quality test without human intervention between the inlet 106 and the outlet 108. Only optionally, a user access may be possible via input/output unit 135. The automated character of the apparatus 100 may accelerate the quality test and may render the quality test more accurate while reducing human resources required in terms of quality testing. Furthermore, the throughput may be increased.

**Figure 3** illustrates details of an apparatus 100 for carrying out a quality test of a component carrier structure 102 according to an exemplary embodiment of the invention. Figure 3 illustrates a specific embodiment showing elements of the apparatus 100 of Figure 2.

An input section 125 relates to a portion of the apparatus 100 between inlet 106 and material removal. A cross-sectioning station 127 corresponds so a subsequent portion of the apparatus 100 at which a cross-section of the component carrier structure 102 is created in a fully automated way by grinding and subsequently polishing. An output section 129 relates to a portion of the apparatus 100 between cross-sectioning station 127 and outlet 108.

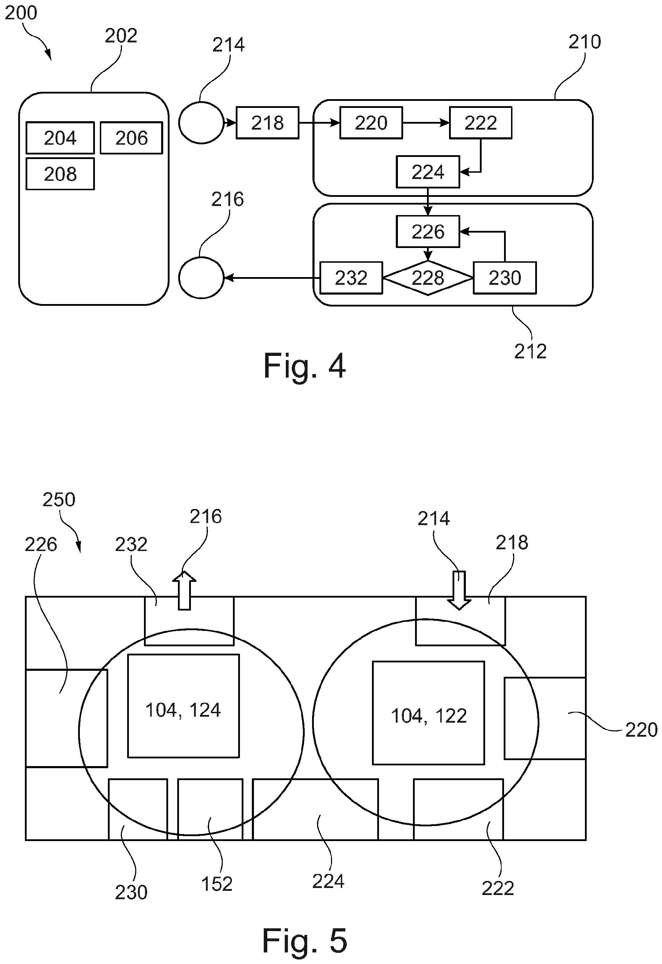

**Figure 4** illustrates a process flow 200 of a method of carrying out a quality test of a component carrier structure 102 according to an exemplary embodiment of the invention.

A section 202 of the process flow 200 relates to coupon-related characteristics of a method according to exemplary embodiments. As indicated by reference sign 204, a coupon (or any other component carrier structure 102) may be coded, for instance for enabling identification thereof (as described referring to Figure 2 in terms of identification unit 110). As indicated by reference sign 206, the coupon may also be dried. Referring to a reference sign 208, two-dimensional labeling may be carried out. When configured in accordance with section 202, cross-sectioning of the coupon may be carried out without embedding in an encapsulant.

Now making reference to a preparation section 210 and an analysis section 212 of the process flow 200, a coupon taken from a magazine (for instance with a magazine size of 500 pieces) by a coupon input unit 218 may be processed between a start block 214 and a termination block 216.

In the preparation section 210, the sample or coupon (as component carrier structure 102) is cut out or milled out from a panel-type larger body 160, see block 220. Referring to block 222, the component carrier structure 102 may then be subjected to thermal stress (for instance by floating the component carrier structure 102 on a bath of molten solder). Thereafter, the component carrier structure 102 may be subjected to a material removal process followed by a surface roughness reduction process. In a corresponding block 224, the component carrier structure 102 may thus be ground and polished.

Thereafter, the component carrier structure 102 may proceed to analysis in section 212. In this context, an optical analysis of the component carrier structure 102 may be carried out, in particular by imaging the latter (compare block 226). In a subsequent block 228, the component carrier structure 102 may undergo an optional etching process. If no etching is carried out, the component carrier structure 102 may proceed to a sample output and archive block 232, and the processing may be completed. If etching is carried out, the component carrier structure 102 may be microetched in a block 230 and may then be returned to block 226 for an additional optical analysis.

**Figure 5** illustrates an automated cell 250 of an apparatus 100 for carrying out a quality test of a component carrier structure 102 according to an exemplary embodiment of the invention.

A component carrier structure 102 is inserted into the automated cell 250 using a coupon magazine, see start block 214 and coupon input unit 218. The component carrier structure 102 may then proceed, handled by a first robot constituting inlet handling subunit 122 of handling unit 104, to a cutout station indicated by block 220. Thereafter, the component carrier structure 102 is subjected to a stress test, compare block 222. After this, the component carrier structure 102 may undergo a grinding (and preferably polishing) process, as indicated again by block 224.

Thereafter, handling of the component carrier structure 102 may be accomplished by a second robot constituting outlet handling subunit 124 of handling unit 104. In other words, the component carrier structure 102 may be handed over from inlet handling subunit 122 to outlet handling subunit 124, wherein the material removal unit 112 constitute the interface between said subunits 122, 124.

After that, the component carrier structure 102 may be subjected to cleaning (see cleaning unit 152), etching (see block 230) and optical analysis (compare block 226). If required or desired, the sequence of grinding, polishing, cleaning, etching and/or optical analysis may be repeated iteratively once or multiple times.

Finally, the component carrier structure 102 may be output out of cell 250 by an output drawer (see block 232).

It should be noted that the term "comprising" does not exclude other elements or steps.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention, whose scope is defined by the appended claims.

## Claims

1. Apparatus (100) for carrying out a quality test of a component carrier structure (102), wherein the apparatus (100) comprises:
a handling unit (104) configured for handling the component carrier structure (102) at least along a portion between an inlet (106) and an outlet (108) of the apparatus (100);
an identification unit (110) configured for identifying the component carrier structure (102) undergoing the quality test;
a material removal unit (112) configured for removing material of the component carrier structure (102) for exposing an interior of the component carrier structure (102) undergoing the quality test;
a determining unit (114) configured for determining at least one pre-defined test target (116) of the component carrier structure (102) after said material removal; and
an evaluation unit (118) configured for evaluating a characteristic of the determined at least one test target (116) of the component carrier structure (102) for assessing the quality of the component carrier structure (102).

2. The apparatus (100) according to claim 1, wherein the handling unit (104) comprises at least one robot (120), in particular a multi-axis robot.

3. The apparatus (100) according to claim 1 or 2, wherein the handling unit (104) comprises an inlet handling subunit (122) configured for handling the component carrier structure (102) along a sub-portion of the apparatus (100) following the inlet (106), in particular between the inlet (106) and the material removal unit (112).

4. The apparatus (100) according to any of claims 1 to 3, wherein the handling unit (104) comprises an outlet handling subunit (124) configured for handling the component carrier structure (102) along a sub-portion of the apparatus (100) extending up to the outlet (108), in particular between the material removal unit (112) and the outlet (108).

5. The apparatus (100) according to any of claims 1 to 4, wherein the identification unit (110) is configured for identifying the component carrier structure (102) based on a detection of an identifier (126) on and/or in the component carrier structure (102).

6. The apparatus (100) according to claim 5, wherein the identification unit (110) is configured for identifying the component carrier structure (102) by matching the detected identifier (126) with correlated identity information in a database (128).

7. The apparatus (100) according to any of claims 1 to 6, comprising at least one of the following features:
wherein the identification unit (110) is configured for retrieving, in particular from a database (128), quality test related information and/or instructions indicative of the quality test to be carried out for the identified component carrier structure (102);
wherein the material removal unit (112) is configured for removing material of the component carrier structure (102) by grinding;
wherein the material removal unit (112) is configured for removing material of the component carrier structure (102) by one of the group consisting of cross-sectional grinding and flat grinding;
wherein the determining unit (114) is configured for processing at least one image at least of the at least one pre-defined test target (116) detected after said material removal;
wherein the at least one test target (116) of the component carrier structure (102) comprises at least one of the group consisting of at least one drill hole (158), and at least one layer structure (130, 132);
wherein the characteristic of the at least one test target (116) of the component carrier structure (102) comprises at least one of the group consisting of a diameter (D) of a drill hole (158), a distance (L) between adjacent drill holes (158), a width of an electrically conductive trace of an electrically conductive layer structure (130), a distance between adjacent electrically conductive traces of an electrically conductive layer structure (130), a thickness (d) of a layer structure (130, 132), a planarity of a layer structure (130, 132), delamination of a layer structure (130, 132), and any feature of a printed circuit board-type component carrier structure (102);
wherein the evaluation unit (118) is configured for assessing the quality by classifying the component carrier structure (102) into one of a plurality of pre-defined quality classes, in particular in one quality class of a group of quality classes consisting of "pass", "fail", and "further analysis required";
wherein the evaluation unit (118) comprises an artificial intelligence module (134) configured for carrying out the evaluation using artificial intelligence, in particular machine learning, more particularly a neural network.

8. The apparatus (100) according to any of claims 1 to 7,
wherein the apparatus (100) comprises an inlet accommodation unit (136) arranged at the inlet (106) and configured for accommodating, in particular in a stacked fashion, a plurality of component carrier structures (102) before testing;
wherein the handling unit (104) is configured for transferring a component carrier structure (102) to be tested from the inlet accommodation unit (136) through the inlet (106), in particular to the identification unit (110).

9. The apparatus (100) according to any of claims 1 to 8,
wherein the apparatus (100) comprises an outlet accommodation unit (138) arranged at the outlet (108) and configured for accommodating, in particular in a stacked fashion, a plurality of component carrier structures (102) after testing;
wherein the handling unit (104) is configured for transferring a tested component carrier structure (102) through the outlet (108) to the outlet accommodation unit (138).

10. The apparatus (100) according to any of claims 1 to 9, comprising at least one of the following features:
comprising a polishing unit (140) configured for polishing an exposed surface of the component carrier structure (102) after removing material;
comprising a removed material quantification unit (142) configured for quantifying an amount of material removed from the component carrier structure (102) by the material removal unit (112);
comprising an encapsulation unit (144) configured for encapsulating the component carrier structure (102) in an encapsulant (146) so that the component carrier structure (102) is subjected to the determination in the encapsulant (146);
wherein the determining unit (114) is configured for determining the at least one pre-defined test target (116) based on a non-encapsulated component carrier structure (102);
comprising a singularization unit (148) configured for singularizing the component carrier structure (102) from a larger body (160), in particular from a panel, before supplying the component carrier structure (102) to the material removal unit (112);
comprising a thermal stress exposing unit (150) configured for exposing the component carrier structure (102) to thermal stress before supplying the component carrier structure (102) to the determining unit (114), wherein in particular the thermal stress exposing unit (150) is configured for exposing the component carrier structure (102) to a thermal stress bath, in particular for floating the component carrier structure (102) on a thermal stress bath, more particularly on molten solder;
comprising a cleaning unit (152) configured for cleaning the component carrier structure (102) after the material removal and before the determining, in particular in an ultrasonic bath;
comprising an alignment unit (154), in particular comprising a multi-axis robot, configured for aligning the component carrier structure (102) before the determining and/or before the material removal, in particular based on at least one alignment feature of the component carrier structure (102);
wherein the determining unit (114) is configured for determining the at least one pre-defined test target (116) in a coarse manner based on a detected first image of the component carrier structure (102), and determining the at least one pre-defined test target (116) in a refined manner based on a detected second image of the component carrier structure (102) detected after detecting the first image, and in particular after etching a surface of the component carrier structure (102).

11. The apparatus (100) according to any of claims 1 to 10, comprising at least one of the following features:
comprising a detection unit (162) configured for detecting image data of an interior of the component carrier structure (102) after said material removal;
wherein the determining unit (114) is configured for determining the at least one pre-defined test target (116) by iteratively repeating a sequence comprising material removal, image detection, and optionally image evaluation;
wherein the apparatus (100) is configured for carrying out the quality test without human intervention between the inlet (106) and the outlet (108).

12. A method of carrying out a quality test of a component carrier structure (102) by an automated apparatus (100), wherein the method comprises:
handling the component carrier structure (102) at least along a portion between an inlet (106) and an outlet (108) of the apparatus (100);
identifying the component carrier structure (102) undergoing the quality test;
removing material of the component carrier structure (102) for exposing an interior of the component carrier structure (102) undergoing the quality test;
determining at least one pre-defined test target (116) of the component carrier structure (102) after said material removal; and
evaluating a characteristic of the determined at least one test target (116) of the component carrier structure (102) for assessing the quality of the component carrier structure (102).

13. The method according to claim 12, comprising at least one of the following features:
wherein the component carrier structure (102) comprises one of the group consisting of a panel comprising multiple connected preforms of component carriers, an array comprising multiple connected preforms of component carriers, a preform of a component carrier, a coupon, and a component carrier, in particular one of a printed circuit board and an integrated circuit substrate;
wherein the method comprises determining the at least one pre-defined test target (116) based on a non-encapsulated component carrier structure (102);
wherein the method comprises carrying out the quality test without human intervention between the inlet (106) and the outlet (108).

14. A computer-readable medium, in which a computer program of carrying out a quality test of a component carrier structure (102) by an automated apparatus (100) is stored, which computer program, when being executed by one or a plurality of processors (156), is adapted to cause an apparatus according to any of claims 1 to 11 to execute the steps of a method according to any of claims 12 or 13.

15. A program element of carrying out a quality test of a component carrier structure (102) by an automated apparatus (100), which program element, when being executed by one or a plurality of processors (156), is adapted to cause an apparatus according to claims 1 to 11 to execute the steps of a method according to any of claims 12 or 13.

## Patentansprüche

1. Vorrichtung (100) zum Ausführen eines Qualitätstests einer Komponententrägerstruktur (102), wobei die Vorrichtung (100) aufweist:
eine Handhabungseinheit (104), welche konfiguriert ist zum Handhaben der Komponententrägerstruktur (102) zumindest entlang eines Abschnitts zwischen einem Einlass (106) und einem Auslass (108) der Vorrichtung (100);
eine Identifizierungseinheit (110), welche konfiguriert ist zum Identifizieren der Komponententrägerstruktur (102), welche dem Qualitätstest unterzogen wird;
eine Materialentfernungseinheit (112), welche konfiguriert ist zum Entfernen von Material der Komponententrägerstruktur (102) zum Freilegen eines Inneren der Komponententrägerstruktur (102), welche dem Qualitätstest unterzogen wird;
eine Bestimmungseinheit (114), welche konfiguriert ist zum Bestimmen mindestens eines vordefinierten Testziels (116) der Komponententrägerstruktur (102) nach der Materialentfernung; und
eine Evaluierungseinheit (118), welche konfiguriert ist zum Evaluieren einer Eigenschaft des bestimmten mindestens einen Testziels (116) der Komponententrägerstruktur (102) zum Bewerten der Qualität der Komponententrägerstruktur (102).

2. Die Vorrichtung (100) gemäß Anspruch 1, wobei die Handhabungseinheit (104) mindestens einen Roboter (120) aufweist, insbesondere einen mehrachsigen Roboter.

3. Die Vorrichtung (100) gemäß Anspruch 1 oder 2, wobei die Handhabungseinheit (104) eine Einlass-Handhabungsteileinheit (122) aufweist, welche konfiguriert ist zum Handhaben der Komponententrägerstruktur (102) entlang eines Teilabschnitts der Vorrichtung (100), welcher auf den Einlass (106) folgt, insbesondere zwischen dem Einlass (106) und der Materialentfernungseinheit (112).

4. Die Vorrichtung (100) gemäß einem beliebigen der Ansprüche 1 bis 3, wobei die Handhabungseinheit (104) eine Auslass-Handhabungsteileinheit (124) aufweist, welche konfiguriert ist zum Handhaben der Komponententrägerstruktur (102) entlang eines Teilabschnitts der Vorrichtung (100), welcher sich bis zu dem Auslass (108) erstreckt, insbesondere zwischen der Materialentfernungseinheit (112) und dem Auslass (108).

5. Die Vorrichtung (100) gemäß einem beliebigen der Ansprüche 1 bis 4, wobei die Identifizierungseinheit (110) konfiguriert ist zum Identifizieren der Komponententrägerstruktur (102) basierend auf einer Detektion eines Identifizierers (126) auf und/oder in der Komponententrägerstruktur (102).

6. Die Vorrichtung (100) gemäß Anspruch 5, wobei die Identifizierungseinheit (110) konfiguriert ist zum Identifizieren der Komponententrägerstruktur (102) mittels Abgleichens des detektierten Identifizierers (126) mit einer korrelierten Identitätsinformation in einer Datenbank (128).

7. Die Vorrichtung (100) gemäß einem beliebigen der Ansprüche 1 bis 6, aufweisend mindestens eines der folgenden Merkmale:
wobei die Identifizierungseinheit (110) konfiguriert ist zum Abfragen, insbesondere von einer Datenbank (128), einer qualitätstestbezogenen Information und/oder von Anweisungen, welche für den Qualitätstest indikativ sind, welcher für die identifizierte Komponententrägerstruktur (102) auszuführen ist;
wobei die Materialentfernungseinheit (112) konfiguriert ist zum Entfernen von Material der Komponententrägerstruktur (102) mittels Schleifens;
wobei die Materialentfernungseinheit (112) konfiguriert ist zum Entfernen von Material der Komponententrägerstruktur (102) mittels einem aus der Gruppe, bestehend aus Querschnittsschleifen und flachem Schleifen;
wobei die Bestimmungseinheit (114) konfiguriert ist zum Verarbeiten mindestens eines Bildes zumindest von dem mindestens einen vordefinierten Testziel (116), welches nach der Materialentfernung detektiert ist;
wobei das mindestens eine Testziel (116) der Komponententrägerstruktur (102) mindestens eines aus der Gruppe aufweist, bestehend aus mindestens einem Bohrloch (158) und mindestens einer Schichtstruktur (130, 132);
wobei die Eigenschaft des mindestens einen Testziels (116) der Komponententrägerstruktur (102) mindestens eines aus der Gruppe aufweist, bestehend aus einem Durchmesser (D) eines Bohrlochs (158), einem Abstand (L) zwischen benachbarten Bohrlöchern (158), einer Breite einer elektrisch leitfähigen Bahn einer elektrisch leitfähigen Schichtstruktur (130), einem Abstand zwischen benachbarten elektrisch leitfähigen Bahnen einer elektrisch leitfähigen Schichtstruktur (130), einer Dicke (d) einer Schichtstruktur (130, 132), einer Ebenheit einer Schichtstruktur (130, 132), einer Delaminierung einer Schichtstruktur (130, 132), und einem beliebigen Merkmal einer gedruckten leiterplattenartigen Komponententrägerstruktur (102);
wobei die Evaluierungseinheit (118) konfiguriert ist zum Bewerten der Qualität mittels Klassifizierens der Komponententrägerstruktur (102) in eine von einer Mehrzahl von vordefinierten Qualitätsklassen, insbesondere in eine Qualitätsklasse aus einer Gruppe von Qualitätsklassen, bestehend aus "bestanden", "durchgefallen", und "weitere Analyse erforderlich";
wobei die Evaluierungseinheit (118) ein Künstliche Intelligenz Modul (134) aufweist, welches konfiguriert ist zum Ausführen der Evaluierung unter Verwendung künstlicher Intelligenz, insbesondere Maschinenlernen, weiter insbesondere eines neuronalen Netzwerks.

8. Die Vorrichtung (100) gemäß einem beliebigen der Ansprüche 1 bis 7,
wobei die Vorrichtung (100) eine Einlassaufnahmeeinheit (136) aufweist, welche an dem Einlass (106) angeordnet ist und konfiguriert ist zum Aufnehmen, insbesondere in einer gestapelten Weise, einer Mehrzahl von Komponententrägerstrukturen (102) vor dem Testen;
wobei die Handhabungseinheit (104) konfiguriert ist zum Übertragen einer zu testenden Komponententrägerstruktur (102) von der Einlassaufnahmeeinheit (136) durch den Einlass (106), insbesondere zu der Identifizierungseinheit (110).

9. Die Vorrichtung (100) gemäß einem beliebigen der Ansprüche 1 bis 8,
wobei die Vorrichtung (100) eine Auslassaufnahmeeinheit (138) aufweist, welche an dem Auslass (108) angeordnet ist und konfiguriert ist zum Aufnehmen, insbesondere in einer gestapelten Weise, einer Mehrzahl von Komponententrägerstrukturen (102) nach dem Testen;
wobei die Handhabungseinheit (104) konfiguriert ist zum Übertragen einer getesteten Komponententrägerstruktur (102) durch den Auslass (108) zu der Auslassaufnahmeeinheit (138).

10. Die Vorrichtung (100) gemäß einem beliebigen der Ansprüche 1 bis 9, aufweisend mindestens eines der folgenden Merkmale:
aufweisend eine Poliereinheit (140), welche konfiguriert ist zum Polieren einer freiliegenden Oberfläche der Komponententrägerstruktur (102) nach dem Entfernen von Material;
aufweisend eine Entferntes-Material-Quantifizierungseinheit (142), welche konfiguriert ist zum Quantifizieren einer Menge des Materials, welches mittels der Materialentfernungseinheit (112) von der Komponententrägerstruktur (102) entfernt ist;
aufweisend eine Einkapselungseinheit (144), welche konfiguriert ist zum Einkapseln der Komponententrägerstruktur (102) in einer Einkapselung (146), so dass die Komponententrägerstruktur (102) der Bestimmung in der Einkapselung (146) unterzogen wird;
wobei die Bestimmungseinheit (114) konfiguriert ist zum Bestimmen des mindestens einen vordefinierten Testziels (116) basierend auf einer nicht eingekapselten Komponententrägerstruktur (102);
aufweisend eine Vereinzelungseinheit (148), welche konfiguriert ist zum Vereinzeln der Komponententrägerstruktur (102) von einem größeren Körper (160), insbesondere von einem Panel, bevor die Komponententrägerstruktur (102) der Materialentfernungseinheit (112) zugeführt wird;
aufweisend eine Thermische-Belastung-Aussetzungseinheit (150), welche konfiguriert ist zum Aussetzen der Komponententrägerstruktur (102) einer thermischen Belastung bevor die Komponententrägerstruktur (102) der Bestimmungseinheit (114) zugeführt wird, wobei insbesondere die Thermische-Belastung-Aussetzungseinheit (150) konfiguriert ist zum Aussetzen der Komponententrägerstruktur (102) einem Thermische-Belastung-Bad, insbesondere zum Floating der Komponententrägerstruktur (102) auf einem Thermische-Belastung-Bad, weiter insbesondere auf einem geschmolzenen Lot;
aufweisend eine Reinigungseinheit (152), welche konfiguriert ist zum Reinigen der Komponententrägerstruktur (102) nach der Materialentfernung und vor dem Bestimmen, insbesondere in einem Ultraschallbad;
aufweisend eine Ausrichtungseinheit (154), insbesondere aufweisend einen mehrachsigen Roboter, welche konfiguriert ist zum Ausrichten der Komponententrägerstruktur (102) vor dem Bestimmen und/oder vor der Materialentfernung, insbesondere basierend auf mindestens einem Ausrichtungsmerkmal der Komponententrägerstruktur (102);
wobei die Bestimmungseinheit (114) konfiguriert ist zum Bestimmen des mindestens einen vordefinierten Testziels (116) in einer groben Weise basierend auf einem detektierten ersten Bild der Komponententrägerstruktur (102), und Bestimmen des mindestens einen vordefinierten Testziels (116) in einer verfeinerten Weise basierend auf einem detektierten zweiten Bild der Komponententrägerstruktur (102), welches nach dem Detektieren des ersten Bildes, und insbesondere nach dem Ätzen einer Oberfläche der Komponententrägerstruktur (102), detektiert wird.

11. Die Vorrichtung (100) gemäß einem beliebigen der Ansprüche 1 bis 10, aufweisend mindestens eines der folgenden Merkmale:
aufweisend eine Detektionseinheit (162), welche konfiguriert ist zum Detektieren von Bilddaten eines Inneren der Komponententrägerstruktur (102) nach der Materialentfernung;
wobei die Bestimmungseinheit (114) konfiguriert ist zum Bestimmen des mindestens einen vordefinierten Testziels (116) mittels iterativen Wiederholens einer Sequenz aufweisend Materialentfernung, Bilddetektion, und optional Bildevaluierung;
wobei die Vorrichtung (100) konfiguriert ist zum Ausführen des Qualitätstests ohne ein menschliches Eingreifen zwischen dem Einlass (106) und dem Auslass (108).

12. Ein Verfahren zum Ausführen eines Qualitätstests einer Komponententrägerstruktur (102) mittels einer automatisierten Vorrichtung (100), wobei das Verfahren aufweist:
Handhaben der Komponententrägerstruktur (102) zumindest entlang eines Abschnitts zwischen einem Einlass (106) und einem Auslass (108) der Vorrichtung (100);
Identifizieren der Komponententrägerstruktur (102), welche dem Qualitätstest unterzogen wird;
Entfernen von Material der Komponententrägerstruktur (102) zum Freilegen eines Inneren der Komponententrägerstruktur (102), welche dem Qualitätstest unterzogen wird;
Bestimmen mindestens eines vordefinierten Testziels (116) der Komponententrägerstruktur (102) nach der Materialentfernung; und
Evaluieren einer Eigenschaft des bestimmten mindestens einen Testziels (116) der Komponententrägerstruktur (102) zum Bewerten der Qualität der Komponententrägerstruktur (102).

13. Das Verfahren gemäß Anspruch 12, aufweisend mindestens eines der folgenden Merkmale:
wobei die Komponententrägerstruktur (102) eines aus der Gruppe aufweist, bestehend aus einem Panel aufweisend mehrere verbundene Vorformen von Komponententrägern, einem Array aufweisend mehrere verbundene Vorformen von Komponententrägern, einer Vorform eines Komponententrägers, einem Coupon, und einem Komponententräger, insbesondere einem von einer gedruckten Leiterplatte und einem integrierten Schaltkreissubstrat;
wobei das Verfahren aufweist
Bestimmen des mindestens einen vordefinierten Testziels (116) basierend auf einer nicht eingekapselten Komponententrägerstruktur (102);
wobei das Verfahren aufweist
Ausführen des Qualitätstests ohne ein menschliches Eingreifen zwischen dem Einlass (106) und dem Auslass (108).

14. Ein computerlesbares Medium, in welchem ein Computerprogramm zum Ausführen eines Qualitätstests einer Komponententrägerstruktur (102) mittels einer automatisierten Vorrichtung (100) gespeichert ist, welches Computerprogramm, wenn es mittels eines oder einer Mehrzahl von Prozessoren (156) ausgeführt wird, eingerichtet ist, eine Vorrichtung gemäß einem beliebigen der Ansprüche 1 bis 11 zu veranlassen, die Schritte des Verfahrens gemäß einem beliebigen der Ansprüche 12 oder 13 auszuführen.

15. Ein Programmelement zum Ausführen eines Qualitätstests einer Komponententrägerstruktur (102) mittels einer automatisierten Vorrichtung (100), welches Programmelement, wenn es mittels eines oder einer Mehrzahl von Prozessoren (156) ausgeführt wird, eingerichtet ist, eine Vorrichtung gemäß den Ansprüchen 1 bis 11 zu veranlassen, die Schritte eines Verfahrens gemäß einem beliebigen der Ansprüche 12 oder 13 auszuführen.

## Revendications

1. Appareil (100) pour effectuer un test de qualité d'une structure de support de composant (102), dans lequel l'appareil (100) comprend :
une unité de manipulation (104) configurée pour manipuler la structure de support de composant (102) au moins le long d'une partie entre une entrée (106) et une sortie (108) de l'appareil (100) ;
une unité d'identification (110) configurée pour identifier la structure de support de composant (102) subissant le test de qualité ;
une unité de retrait de matériau (112) configurée pour retirer du matériau de la structure de support de composant (102) afin d'exposer un intérieur de la structure de support de composant (102) subissant le test de qualité ;
une unité de détermination (114) configurée pour déterminer au moins une cible de test prédéfinie (116) de la structure de support de composant (102) après ledit retrait de matériau ; et
une unité d'évaluation (118) configurée pour évaluer une caractéristique de la au moins une cible de test déterminée (116) de la structure de support de composant (102) afin d'évaluer la qualité de la structure de support de composant (102).

2. Appareil (100) selon la revendication 1, dans lequel l'unité de manipulation (104) comprend au moins un robot (120), en particulier un robot multi-axe.

3. Appareil (100) selon la revendication 1 ou 2, dans lequel l'unité de manipulation (104) comprend une sous-unité de manipulation d'entrée (122) configurée pour manipuler la structure de support de composant (102) le long d'une sous-partie de l'appareil (100) suivant l'entrée (106), en particulier entre l'entrée (106) et l'unité de retrait de matériau (112).

4. Appareil (100) selon l'une quelconque des revendications 1 à 3, dans lequel l'unité de manipulation (104) comprend une sous-unité de manipulation de sortie (124) configurée pour manipuler la structure de support de composant (102) le long d'une sous-partie de l'appareil (100) s'étendant jusqu'à la sortie (108), en particulier entre l'unité de retrait de matériau (112) et la sortie (108).

5. Appareil (100) selon l'une quelconque des revendications 1 à 4, dans lequel l'unité d'identification (110) est configurée pour identifier la structure de support de composant (102) sur la base d'une détection d'un identifiant (126) sur et/ou dans la structure de support de composant (102).

6. Appareil (100) selon la revendication 5, dans lequel l'unité d'identification (110) est configurée pour identifier la structure de support de composant (102) en faisant correspondre l'identificateur détecté (126) avec des informations d'identité corrélées dans une base de données (128).

7. Appareil (100) selon l'une quelconque des revendications 1 à 6, comprenant au moins une des caractéristiques suivantes :
dans lequel l'unité d'identification (110) est configurée pour récupérer, en particulier à partir d'une base de données (128), des informations et/ou des instructions relatives à un test de qualité indiquant le test de qualité à effectuer pour la structure de support de composant identifiée (102) ;
dans lequel l'unité de retrait de matériau (112) est configurée pour retirer du matériau de la structure de support de composant (102) par meulage ;
dans lequel l'unité de retrait de matériau (112) est configurée pour retirer du matériau de la structure de support de composant (102) par l'un du groupe constitué du meulage en section transversale et du meulage à plat ;
dans lequel l'unité de détermination (114) est configurée pour traiter au moins une image d'au moins la au moins une cible de test prédéfinie (116) détectée après ledit retrait de matériau ;
dans lequel la au moins une cible de test (116) de la structure de support de composant (102) comprend au moins l'un du groupe constitué d'au moins un trou de perçage (158), et d'au moins une structure de couche (130, 132) ;
dans lequel la caractéristique de la au moins une cible de test (116) de la structure de support de composant (102) comprend au moins l'un du groupe constitué d'un diamètre (D) d'un trou de perçage (158), d'une distance (L) entre des trous de perçage adjacents (158), d'une largeur d'une trace électroconductrice d'une structure de couche électroconductrice (130), d'une distance entre des traces électroconductrices adjacentes d'une structure de couche électroconductrice (130), d'une épaisseur (d) d'une structure de couche (130, 132), d'une planéité d'une structure de couche (130, 132), d'une délamination d'une structure de couche (130, 132) et de toute caractéristique d'une structure de support de composant (102) de type carte de circuit imprimé ;
dans lequel l'unité d'évaluation (118) est configurée pour évaluer la qualité en classant la structure de support de composant (102) dans l'une d'une pluralité de classes de qualité prédéfinies, en particulier dans une classe de qualité d'un groupe de classes de qualité consistant en « réussite », « échec » et « analyse supplémentaire requise » ;
dans lequel l'unité d'évaluation (118) comprend un module d'intelligence artificielle (134) configuré pour effectuer l'évaluation en utilisant l'intelligence artificielle, en particulier un apprentissage automatique, plus particulièrement un réseau neuronal.

8. Appareil (100) selon l'une quelconque des revendications 1 à 7,
dans lequel l'appareil (100) comprend une unité d'accueil d'entrée (136) agencée au niveau de l'entrée (106) et configurée pour accueillir, en particulier de manière empilée, une pluralité de structures de support de composant (102) avant un test ;
dans lequel l'unité de manipulation (104) est configurée pour transférer une structure de support de composant (102) à tester à partir de l'unité d'accueil d'entrée (136) à travers l'entrée (106), en particulier vers l'unité d'identification (110).

9. Appareil (100) selon l'une quelconque des revendications 1 à 8,
dans lequel l'appareil (100) comprend une unité d'accueil de sortie (138) agencée au niveau de la sortie (108) et configurée pour accueillir, en particulier de manière empilée, une pluralité de structures de support de composant (102) après un test ;
dans lequel l'unité de manipulation (104) est configurée pour transférer une structure de support de composant testée (102) à travers la sortie (108) vers l'unité d'accueil de sortie (138).

10. Appareil (100) selon l'une quelconque des revendications 1 à 9, comprenant au moins l'une des caractéristiques suivantes :
comprenant une unité de polissage (140) configurée pour polir une surface exposée de la structure de support de composant (102) après avoir retiré du matériau ;
comprenant une unité de quantification de matériau retiré (142) configurée pour quantifier une quantité de matériau retiré à partir de la structure de support de composant (102) par l'unité de retrait de matériau (112) ;
comprenant une unité d'encapsulation (144) configurée pour encapsuler la structure de support de composant (102) dans un encapsulant (146) de telle sorte que la structure de support de composant (102) soit soumise à la détermination dans l'encapsulant (146) ;
dans lequel l'unité de détermination (114) est configurée pour déterminer la au moins une cible de test prédéfinie (116) sur la base d'une structure de support de composant non encapsulée (102) ;
comprenant une unité de singularisation (148) configurée pour singulariser la structure de support de composant (102) à partir d'un corps plus grand (160), en particulier à partir d'un panneau, avant de fournir la structure de support de composant (102) à l'unité de retrait de matériau (112) ;
comprenant une unité d'exposition à une contrainte thermique (150) configurée pour exposer la structure de support de composant (102) à une contrainte thermique avant de fournir la structure de support de composant (102) à l'unité de détermination (114), dans lequel en particulier l'unité d'exposition à une contrainte thermique (150) est configurée pour exposer la structure de support de composant (102) à un bain de contrainte thermique, en particulier pour faire flotter la structure de support de composant (102) sur un bain de contrainte thermique, plus particulièrement sur du métal d'apport de brasage fondu ;
comprenant une unité de nettoyage (152) configurée pour nettoyer la structure de support de composant (102) après le retrait de matériau et avant la détermination, en particulier dans un bain à ultrasons ;
comprenant une unité d'alignement (154), en particulier comprenant un robot multi-axe, configurée pour aligner la structure de support de composant (102) avant la détermination et/ou avant le retrait de matériau, en particulier sur la base d'au moins une caractéristique d'alignement de la structure de support de composant (102) ;
dans lequel l'unité de détermination (114) est configurée pour déterminer la au moins une cible de test prédéfinie (116) d'une manière grossière sur la base d'une première image détectée de la structure de support de composant (102), et pour déterminer la au moins une cible de test prédéfinie (116) d'une manière affinée sur la base d'une seconde image détectée de la structure de support de composant (102) détectée après la détection de la première image, et en particulier après la gravure d'une surface de la structure de support de composant (102).

11. Appareil (100) selon l'une quelconque des revendications 1 à 10, comprenant au moins l'une des caractéristiques suivantes :
comprenant une unité de détection (162) configurée pour détecter des données d'image d'un intérieur de la structure de support de composant (102) après ledit retrait de matériau ;
dans lequel l'unité de détermination (114) est configurée pour déterminer la au moins une cible de test prédéfinie (116) en répétant de manière itérative une séquence comprenant un retrait de matériau, une détection d'image et facultativement une évaluation d'image ;
dans lequel l'appareil (100) est configuré pour effectuer le test de qualité sans intervention humaine entre l'entrée (106) et la sortie (108).

12. Procédé pour effectuer un test de qualité d'une structure de support de composant (102) par l'intermédiaire d'un appareil automatisé (100), dans lequel le procédé comprend les étapes consistant à :
manipuler la structure de support de composant (102) au moins le long d'une partie entre une entrée (106) et une sortie (108) de l'appareil (100) ;
identifier la structure de support de composant (102) subissant le test de qualité ;
retirer du matériau de la structure de support de composant (102) pour exposer un intérieur de la structure de support de composant (102) subissant le test de qualité ;
déterminer au moins une cible de test prédéfinie (116) de la structure de support de composant (102) après ledit retrait de matériau ; et
évaluer une caractéristique de la au moins une cible de test déterminée (116) de la structure de support de composant (102) pour évaluer la qualité de la structure de support de composant (102).

13. Procédé selon la revendication 12, comprenant au moins l'une des caractéristiques suivantes :
dans lequel la structure de support de composant (102) comprend l'un du groupe constitué d'un panneau comprenant de multiples préformes connectées de supports de composant, d'un réseau comprenant de multiples préformes connectées de supports de composant, d'une préforme d'un support de composant, d'un coupon et d'un support de composant, en particulier l'un d'une carte de circuit imprimé et d'un substrat de circuit intégré ;
dans lequel le procédé comprend une détermination de la au moins une cible de test prédéfinie (116) sur la base d'une structure de support de composant non encapsulée (102) ;
dans lequel le procédé comprend une réalisation du test de qualité sans intervention humaine entre l'entrée (106) et la sortie (108).

14. Support lisible par ordinateur, dans lequel est stocké un programme informatique d'exécution d'un test de qualité d'une structure de support de composant (102) par un appareil automatisé (100), lequel programme informatique, lorsqu'il est exécuté par un ou une pluralité de processeurs (156), est adapté pour amener un appareil selon l'une quelconque des revendications 1 à 11 à exécuter les étapes de procédé selon l'une quelconque des revendications 12 ou 13.

15. Élément de programme pour effectuer un test de qualité d'une structure de support de composant (102) par un appareil automatisé (100), lequel élément de programme, lorsqu'il est exécuté par un ou une pluralité de processeurs (156), est adapté pour amener un appareil selon les revendications 1 à 11 à exécuter les étapes d'un procédé selon l'une quelconque des revendications 12 ou 13.
